# EUROPEAN PATENT SPECIFICATION

(11) **EP 1 505 562 B1**
(45) Date of publication and mention of the grant of the patent: **24.01.2007**
(21) Application number: 04016407.1
(22) Date of filing: 13.07.2004
(51) Int. Cl.: G09G 3/28, H03K 4/62

(54) **Device for generating a voltage ramp in a control circuit for a plasma display**
Vorrichtung zur Erzeugung eines rampenförmigen Spannungsverlaufes in einer Steuerschaltung für einen Plasmabildschirm
Dispositif de génération d'une rampe de tension dans un circuit de commande pour écran de plasma

(30) Priority: 05.08.2003 FR 0309679
(43) Date of publication of application: 09.02.2005
(73) Proprietor: Thomson Licensing, 92100 Boulogne-Billancourt (FR)
(72) Inventor: Bezal, Jean-Raphael, 92648 Boulogne Cedex (FR); Morizot, Gérard, 92648 Boulogne Cedex (FR); Marchand, Philippe, 92648 Boulogne Cedex (FR)
(74) Representative: Le Dantec, Claude

(56) References cited:
- WO-A-03/058590
- US-A1- 2003 107 532
- WU T-F ET AL: "A SWITCH-MODE APPROACH TO EFFICIENTLY AND FLEXIBLE GENERATING RESET WAVEFORMS FOR AC PDPS" IEEE TRANSACTIONS ON INDUSTRY APPLICATIONS, IEEE INC. NEW YORK, US, vol. 39, no. 2, March 2003 (2003-03), pages 431-442, XP001158278 ISSN: 0093-9994

## Description

The present invention relates to a device for generating a voltage ramp in a plasma display panel.

Plasma display panels, called hereafter PDPs, are flat displays. They generally comprise two parallel insulating plates, each bearing one or more arrays of electrodes and defining between them a gas-filled space. The plates are joined together so as to define intersections between the electrodes of these arrays. Each intersection of electrodes defines an elementary cell to which corresponds a gas space partially bounded by barrier ribs and in which an electrical discharge takes place when the cell is activated. Conventionally, two arrays of crossed electrodes, each array being placed on a different plate, serve for addressing discharges in the cells, and two arrays of parallel coplanar electrodes serve to sustain these discharges. In general, one of the arrays of coplanar electrodes serves both for addressing and sustaining. The panel therefore comprises three arrays of electrodes. In the rest of the description, the array of electrodes serving only for addressing the cells of the PDP is denoted by A, the array of electrodes serving only to sustain the cells of the PDP is denoted by X and the array of electrodes serving both to address and sustain the cells of the PDP is denoted by Y. The arrays X and Y placed on the same plate and the electrodes of the array A are orthogonal to those of the array X and of the array Y. These arrays are covered with a dielectric layer, especially to provide a memory effect. This dielectric layer is itself covered with a protective and secondary-electron emission layer, generally based on magnesia.

Each electrode of the array X forms with an electrode of the array Y a pair of electrodes defining between them a succession of light discharge regions, generally distributed along a row of discharge regions of the panel. The electrode arrays X and Y therefore supply rows of discharge regions, whereas the electrode array A serving only for addressing supplies columns of discharge regions. The light discharge regions form a two-dimensional matrix on the panel.

The adjacent discharge regions, at least those that emit different colours, are generally bounded by barrier ribs. The walls of the light discharge regions are generally partially coated with phosphors sensitive to the ultraviolet radiation from the light discharges. Adjacent discharge regions are provided with phosphors emitting different primary colours, so that the combination of three adjacent regions forms an image element or pixel.

When the plasma panel is in operation, to display an image, a succession of display or sub-display operations is carried out using the matrix of discharge regions. Each sub-display operation generally comprises the following steps:
- firstly, a selective address step, the purpose of which is to modify the electrical charges on the dielectric layer in each of the discharge regions to be activated, by applying at least one voltage pulse between the electrodes of the arrays A and Y that cross in these regions; and
- then, a non-selective sustain step during which a succession of voltage pulses is applied between the electrodes of the arrays X and Y so as to cause a succession of light discharges only in the discharge regions that have been activated beforehand.

After a sub-display operation, the discharge regions may be in very different internal electrical voltage states, especially depending on whether these regions have or have not been activated during this sub-display operation; other factors contribute to this dispersion of the internal voltage states, such as the nature of the phosphors corresponding to these regions, the inevitable fluctuations in the dimensional characteristics of these discharge regions, and the fluctuations in the composition of the surface of the walls of these regions, which are due to the panel manufacturing processes.

In order for the internal voltage state of the discharge regions to be addressed to be made uniform, most of the address steps are preceded by a step of resetting these regions, the purpose of which is essentially to reset all the discharge regions to be addressed in the same internal voltage state, whether or not they have been activated during the preceding sub-display operation; this reset step conventionally comprises an electric charge priming operation followed by a charge adjustment operation, also called an "erase" operation in which these charges are erased and after which, ideally, the internal voltages within each discharge region are close to the ignition thresholds for the said regions.

For each pair of address or sustain electrodes of a discharge region, it is possible to associate an external voltage applied between these electrodes and an internal voltage in the gas space separating the materials that cover these electrodes. The internal voltage generally differs from the external voltage owing to the surface charges that occur on the surface of the insulating materials that cover the electrodes, and the interface between these dielectrics and the gas in the discharge region.

These surface charges result, on the one hand, from a capacitive effect due to the dielectric properties of the materials that define the discharge regions and, on the other hand, from an accumulation of charges called "memory" charges that are produced by the preceding discharges within the gas in these discharge regions.

These priming and erase operations are generally carried out by applying a voltage ramp to the electrodes of the array Y of the PDP, the potential on the electrodes of the arrays X or A of the PDP being kept constant. More precisely, the priming of electrical charges on the cells of the PDP is obtained by applying a rising voltage ramp to the electrodes of the array Y and the adjustment of the charges is obtained by applying a falling voltage ramp again to the electrodes of the array Y of the PDP.

At the present time, in plasma panels, the voltage ramps are generated by circuits using DC voltage sources and power transistors operating in linear mode. This operation of the transistors in linear mode therefore introduces energy losses that obey a law of the CV²F type where C represents the overall capacitance of the group of cells to be set, this capacitance being that of the electrode array Y relative to the two other arrays A and X, V is the maximum charging voltage to be reached, which is around 400 to 600 V, and F is the number of charges and discharges in the cells per second. The corresponding power reached at the present time is about 10 W. It is worthwhile reducing this energy loss, not only in order to improve the energy efficiency of the device, but also to reduce the temperature rise of the transistors that expend this energy and thus reduce the dimensions of these transistors and of the heat sinks serving to dissipate this energy.

To reduce these losses, it is known to create a resonance of the capacitance of the plasma panel with an inductor. Such a device is disclosed in International Patent Application WO 02/058041 filed in the name of LG Electronics Inc. In that device, the energy losses obey a law of the R_{P}i² type where R_{P} is the residual resistance of the device, the said residual resistance being able to be reduced by choosing weakly resistive components, something which represents a cost. That device also has the following drawbacks:
- the waveform of the voltage generated is not a linearly varying voltage ramp but a portion of a sinusoid, the waveform of which is defined by a value of the inductor employed to create the resonance;
- since the overall capacitance of the panel is around 80 nF to 100 nF, the value of the inductor must therefore be relatively high in order to comply with the necessary rise and fall times for the priming and erasing ramps;
- in production, the slope for a given panel can be optimized only by mechanically adjusting the value of the inductor, which is difficult because of the high value of the latter; and
- finally, the device requires an additional voltage source, in addition to those used for addressing and sustaining the cells.

Another circuit arrangement for the AC power supply of a plasma display panel is known from WO 03/058590 A1. The present invention proposes a device for generating voltage ramps in plasma panels that generates small energy losses and completely or partly alleviates the aforementioned drawbacks.

The present invention relates to a device for generating a voltage ramp in a plasma display panel comprising a plurality of cells, the said voltage ramp being applied to electrodes of the cells of the plasma display panel in order to prime and/or reset electrical charges on the walls of the said cells. The said device comprises:
- a DC voltage source comprising a positive terminal and a negative terminal, and generating a positive DC voltage ;
- first and second switches connected in series between the positive terminal and the negative terminal of the DC voltage source, first and second diodes being connected respectively in parallel with the said first and second switches, the cathode of the said first diode being connected to the positive terminal of the DC voltage source and the anode of the said second diode being connected to the negative terminal of the DC voltage source;
- an inductor, a first end of which is connected to a point located between the said first and second switches, in order to form a resonance circuit with the capacitive load of the cells of the said panel;
- third and fourth switches connected in series between the said electrodes of the cells of the plasma display panel, third and fourth diodes being connected respectively in parallel with the said third and fourth switches, the cathode of the said third diode being connected to one electrode of the cells of the panel and the anode of the said fourth diode being connected to another electrode of the cells of the panel and to the negative terminal of the DC voltage source; and
- a control circuit for turning the switches off and on in order to generate a programmable voltage ramp on the electrodes of the cells of the panel, wherein, to generate the said voltage ramp, at least one of the said switches operates in chopping mode.

Other features and advantages will become apparent on reading the description that follows, this being given with reference to the appended drawings in which:
- Figure 1 is a device for generating a ramp with a rising or falling edge according to the invention; and
- Figure 2 is a voltage curve illustrating the various operating phases of the device of Figure 1.

According to the invention, the switches of the device operate in a chopping mode in order to generate the voltage ramps. The voltage ramps generated may be rising or falling, it being possible for this rise or fall to be linear or non-linear.

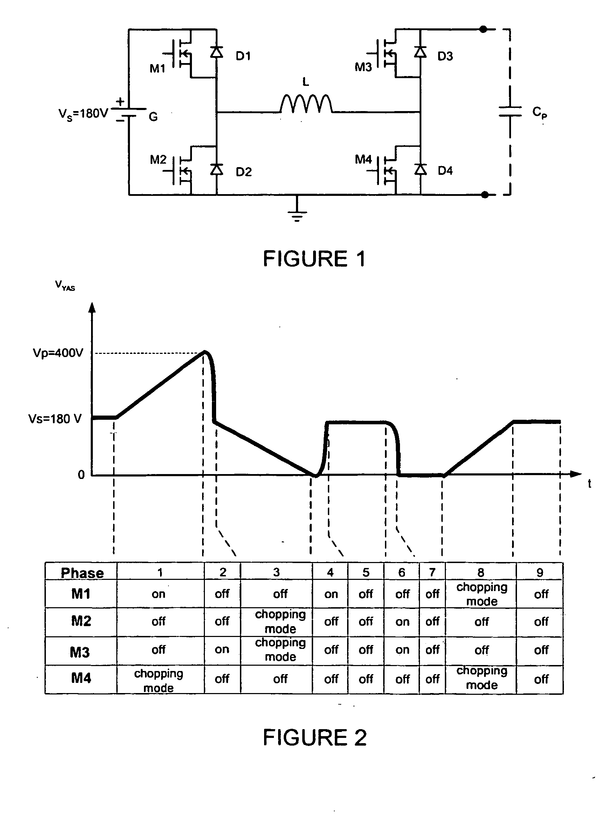

Figure 1 illustrates a device according to the invention. The device comprises a DC voltage source G delivering a voltage V_{S}, four switches M1, M2, M3 and M4, four diodes D1, D2, D3 and D4 and an inductor. C_{P} denotes the capacitive load of the panel.

The switches M1 and M2 are connected in series between the positive and negative terminals of the DC voltage source G. In the present example, the negative terminal of the source G is connected to earth, without this being necessary. The switches are MOS power transistors. The drain of the transistor M1 is connected to the positive terminal of the voltage source G, its source is connected to the drain of the transistor M2, and the source of the transistor M2 is connected to the negative terminal of the voltage source G. Moreover, the diode D1 is connected in parallel with the transistor M1, its cathode being connected to the positive terminal of the voltage source G, and the diode D2 is connected in parallel with the transistor M2, its anode being connected to the negative terminal of the voltage source G.

The switches M3 and M4 are connected in series between the electrodes of the array Y of the plasma panel and the negative terminal of the voltage source G. The drain of the transistor forming the switch M3 is connected to the electrodes of the array Y and its source is connected to the drain of the transistor forming the switch M4. The source of the transistor M4 is connected to the negative terminal of the voltage source G. The diode D3 is connected in parallel with the transistor M3, its cathode being connected to the drain of the transistor M3, and the diode D4 is mounted in parallel with the transistor M4, its anode being connected to the negative terminal of the voltage source G. The inductor L is connected between the mid-point of the switches M1 and M2 and the mid-point of the switches M3 and M4.

A control circuit (not shown) is provided for turning the switches M1 to M4 off and on.

The operation of this device will now be described with reference to Figure 2. Figure 2 shows, in its upper part, an example of a voltage curve delivered by the device of Figure 1 and, in its lower part, a table indicating the states of the switches of the device for each portion of the curve.

The curve in the upper part of Figure 2 illustrates several operating phases of the device of Figure 1. This curve is given by way of example in order to describe the various voltage waveforms that can be obtained with the device of Figure 1. Under actual operating conditions, these phases do not follow one another as indicated in this figure. The purpose of this succession is simply to show that this device makes it possible to generate rising and falling voltage ramps and rising and falling voltage edges.

These phases are denoted by 1 to 9. During each phase, the switches of the device are either in the off-state, or in the on-state, or in a chopping mode in which they alternate between an on-state and an off-state with a chopping frequency f.

The table in the lower part of Figure 2 shows the state of the switches of the device for each operating phase. Each column of the table refers to an operating phase of the device, identified by its number, and each row of the table refers to a switch.

In the table, the switches in an on-state are denoted by "on", the switches in an off-state are denoted by "off" and the switches operating in chopping mode are denoted by "chopping mode".

During phase 1, the voltage signal delivered by the device is a rising voltage ramp superposed on the DC voltage V_{S}. During this phase, the switch M1 is in an on-state, the switches M2 and M3 are in an off-state and the switch M4 operates in chopping mode. The inductor L charges up when the switch M4 is conducting (on-state) and discharges via the diode D3 into the capacitance C_{P} when it is off. During this phase, the voltage delivered by the device reaches V_{P} = 400V. This voltage may be obtained, without an additional voltage generator, thanks to the presence of the inductor L. This positive voltage ramp is especially used during the priming phase of the cells of the plasma panel.

Another method for obtaining this rising voltage ramp consists in making the switch M1 operate in chopping mode in order to obtain better linearity at the start of the ramp. In this operating mode, the operation of the switch M1 is synchronized with that of the switch M4. The inductor L charges up when M1 and M4 are on and discharges via the diodes D2 and D3 into the capacitor Cp when they are off. Each time the switches M1 and M4 are turned off/on, the voltage across the terminals of C_{P} increases by dV_{P}.

During phase 2, the voltage generated is a falling edge dropping from V_{P} to V_{S}. This edge is obtained by turning the switch M3 on and turning the switches M1, M2 and M4 off. The transistor M3 is maintained in the on-state in order for the inductor L to come into resonance with the capacitance C_{P}. Energy is transferred from the capacitance C_{P} to the voltage source G via the diode D1.

During phase 3, the voltage generated is a falling ramp dropping from V_{S} to a lower voltage, for example 0 volts if the negative terminal of the source G is connected to earth. During this phase, the switches M2 and M3 operate in chopping mode and the switches M1 and M4 are in an off-state. The switches M2 and M3 are synchronously controlled and are simultaneously in the same state. When the switches are in the on position, the voltage across the terminals of the capacitance C_{P} lowers and energy is transferred from the capacitance C_{P} to the inductor L and, when they are in the off position, the energy stored in L is transferred to the voltage source G via the diodes D1 and D4.

During phase 4, the voltage generated is a rising edge in resonant mode, going from the voltage V to the voltage V_{S}. During this phase, the switch M1 is in the on position and the others are in the off position. The inductor L forms a resonant circuit with the voltage source V_{S}, the capacitance C_{P} and the diode D3. The switch M1 is maintained in the on position for the time needed for the voltage across the terminals of the capacitance C_{P} to reach the desired value, in this case here the value V_{S}. This is, for example, obtained after complete discharge of the inductor L into the capacitance C_{P}.

Phase 5 corresponds to a rest phase in which all the switches of the device are in the off position. There is no energy transferred during this phase. The voltage V_{S} is maintained in the capacitance C_{P}.

During phase 6, the voltage generated is a falling edge dropping from V_{S} to 0 volts. During this phase, the switches M2 and M3 are in the on-state and the switches M1 and M4 in the off-state. Energy is transferred from the capacitance C_{P} into the inductor L.

Phase 7 is identical to phase 5 and corresponds to a rest phase in which all the switches of the device are in the off position. During this phase, the energy stored in the inductor L is transferred to the voltage source G via the diodes D1 and D4. The voltage across the terminals of the capacitance C_{P} is maintained at zero.

Phase 8 is a phase during which the voltage generated is a rising voltage ramp going from 0 to V_{S}. During this phase, the switches M1 and M4 operate in chopping mode, the other switches being in an off-state. While M1 and M4 are conducting, the inductor L is charged with energy under the voltage V_{S} and then, after M1 and M4 are turned off, the inductor transfers the said energy into the capacitance C_{P} via the diodes D2 and D3.

Finally, phase 9 is a rest phase identical to that of phase 7. The voltage obtained at the end of phase 8 across the terminals of the capacitance C_{P} is maintained across the terminals of the latter.

In practice, the chopping frequency of the switches is between 100 and 500 kHz. At each chopping cycle, the voltage across the terminals of the capacitance C_{P} varies by an amount dV. The slope of the ramp is adjusted by varying the chopping frequency and the conduction time of the switches in chopping mode.

The device of the invention has many advantages, especially the following:
- low losses in the transistors because of their use in chopping mode;
- the possibility of adjusting the slope of the ramp by varying the chopping duty cycle and the frequency of the switches, without being dependent on the tolerances of the inductor; this slope may also be controlled by a control loop that compares the voltage or current information of the panel with an analogue or digital reference ramp;
- the possibility of adapting the slope of the ramp throughout the life of the plasma panel, for example in order to compensate for the change in the magnesia layer in the cells;
- no need for an additional DC voltage source - the voltage source used is already present in the plasma panel for sustaining the cells; and
- the possibility of providing a look-up table for storing several slope values and for automatically regulating the slope of the ramps by reading from the said table.

## Claims

1. Device for generating a voltage ramp in a plasma display panel comprising a plurality of cells, the said voltage ramp being applied to electrodes of the cells of the plasma display panel in order to prime and/or reset electrical charges on the walls of the said cells, said device comprising:
- a DC voltage source (G) comprising a positive terminal and a negative terminal, and generating a positive DC voltage (V_{S});
- first and second switches (M1, M2) connected in series between the positive terminal and the negative terminal of the DC voltage source, first and second diodes (D1, D2) being connected respectively in parallel with the said first and second switches (M1, M2), the cathode of the said first diode (D1) being connected to the positive terminal of the DC voltage source and the anode of the said second diode (D2) being connected to the negative terminal of the DC voltage source;
- an inductor (L), a first end of which is connected to a point located between the said first and second switches (M1, M2), in order to form a resonance circuit with the capacitive load (C_{P}) of the cells of the said panel;
- third and fourth switches (M3, M4) connected in series between the said electrodes of the cells of the plasma display panel, third and fourth diodes (D3, D4) being connected respectively in parallel with the said third and fourth switches (M3, M4), the cathode of the said third diode (D3) being connected to one electrode of the cells of the panel and the anode of the said fourth diode (D4) being connected to another electrode of the cells of the panel and to the negative terminal of the DC voltage source; and
- a control circuit for turning the switches off and on in order to generate a programmable voltage ramp on the electrodes of the cells of the panel, wherein, to generate the said voltage ramp, at least one of the said switches (M1-M4) operates in chopping mode.

2. Device according to Claim 1, **characterized in that**, to generate a rising voltage ramp, the said fourth switch (M4) operates in chopping mode whereas the said first switch (M1) is placed in an on-state and the second and third switches (M2, M3) are placed in an off-state.

3. Device according to Claim 1, **characterized in that**, to generate a rising voltage ramp, the said first and fourth switches (M1, M4) operate synchronously in chopping mode, whereas the said second and third switches (M2, M3) are placed in an off-state.

4. Device according to one of Claims 1 to 3, **characterized in that**, to generate a falling voltage ramp, the said second and third switches (M2, M3) operate synchronously in chopping mode, whereas the said first and fourth switches (M1, M4) are placed in an off-state.

## Patentansprüche

1. Vorrichtung zum Erzeugen eines rampenförmigen Spannungsverlaufs in einer Plasmabildschirmtafel, eine Vielzahl von Zellen umfassend, wobei der genannte rampenförmige Spannungsverlauf an Elektroden der Zellen der Plasmabildschirmtafel angelegt ist, damit elektrische Ladungen an den Wänden der genannten Zellen vorionisiert und/oder zurückgestellt werden, wobei die genannte Vorrichtung umfasst:
- eine Gleichspannungsquelle (G), welche eine positive Anschlussklemme und eine negative Anschlussklemme umfasst und eine positive Gleichspannung (V_{S}) erzeugt;
- erste und zweite Schalter (M1, M2), die in Serie zwischen der positiven Anschlussklemme und der negativen Anschlussklemme der Gleichspannungsquelle angeschlossen sind, wobei erste und zweite Dioden (D1, D2) jeweils parallel zu den genannten ersten und zweiten Schaltern (M1, M2) angeschlossen sind, wobei die Katode der genannten ersten Diode (D1) an die positive Anschlussklemme der Gleichspannungsquelle angeschlossen ist und die Anode der genannten zweiten Diode (D2) an die negative Anschlussklemme der Gleichspannungsquelle angeschlossen ist;
- eine Induktionsspule (L), deren erstes Ende an einen Punkt angeschlossen ist, der zwischen den genannten ersten und zweiten Schaltern (M1, M2) liegt, damit mit der kapazitiven Last (C_{P}) der Zellen der genanten Tafel ein Resonanzkreis gebildet wird;
- dritte und vierte Schalter (M3, M4), die zwischen den genannten Elektroden der Zellen der Bildschirmtafel in Serie angeschlossen sind, wobei dritte und vierte Dioden (D3, D4) jeweils parallel zu den genannten dritten und vierten Schaltern (M3, M4) angeschlossen sind, wobei die Katode der genannten dritten Diode (D3) an eine Elektrode der Zellen der Tafel angeschlossen ist und die Anode der genannten vierten Diode (D4) an eine andere Elektrode der Zellen der Tafel und an die negative Anschlussklemme der Gleichspannungsquelle angeschlossen ist; und
- eine Steuerschaltung zum Aus- und Einschalten der Schalter, damit an den Elektroden der Zellen der Tafel ein programmierbarer rampenförmiger Spannungsverlauf erzeugt wird, wobei, um den genannten rampenförmigen Spannungsverlauf zu erzeugen, mindestens einer der genannten Schalter (M1 bis M4) in zerhackender Betriebsart arbeitet.

2. Vorrichtung nach Anspruch 1, **dadurch gekennzeichnet dass**, um einen ansteigenden rampenförmigen Spannungsverlauf zu erzeugen, der genannte vierte Schalter (M4) in zerhackender Betriebsart arbeitet, während der genannte erste Schalter (M1) in einem Ein-Zustand angeordnet ist und die zweiten und dritten Schalter (M2, M3) in einem Aus-Zustand angeordnet sind.

3. Vorrichtung nach Anspruch 1, **dadurch gekennzeichnet dass**, um einen ansteigenden rampenförmigen Spannungsverlauf zu erzeugen, die genannten ersten und vierten Schalter (M1, M4) synchron in zerhackender Betriebsart arbeiten, während die genannten zweiten und dritten Schalter (M2, M3) in einem Aus-Zustand angeordnet sind.

4. Vorrichtung nach einem der Ansprüche 1 bis 3, **dadurch gekennzeichnet dass**, um einen abfallenden rampenförmigen Spannungsverlauf zu erzeugen, die genannten zweiten und dritten Schalter (M2, M3) synchron in zerhackender Betriebsart arbeiten, während die genannten ersten und vierten Schalter (M1, M4) in einem Aus-Zustand angeordnet sind.

## Revendications

1. Dispositif de génération d'une rampe de tension dans un panneau d'affichage à plasma comprenant une pluralité de cellules, ladite rampe de tension étant appliquée sur des électrodes des cellules du panneau d'affichage au plasma pour former et/ou égaliser des charges électriques présentes sur les parois desdites cellules, ledit dispositif comportant :
- une source de tension continue (G) comprenant une borne positive et une borne négative, et générant une tension continue positive (Vs),
- des premier et deuxième interrupteurs (M1,M2) montés en série entre la borne positive et la borne négative de la source de tension continue, des première et deuxième diodes (D1,D2) étant montées respectivement en parallèle avec lesdits premier et deuxième interrupteurs (M1,M2), la cathode de ladite première diode (D1) étant connectée à la borne positive de la source de tension continue et l'anode de ladite deuxième diode (D2) étant connectée à la borne négative de la source de tension continue,
- une inductance (L) dont une première extrémité est connectée à un point situé entre lesdits premier et deuxième interrupteurs (M1,M2), pour former un circuit de résonance avec la charge capacitive (C_{P}) des cellules dudit panneau;
- des troisième et quatrième interrupteurs (M3,M4) montés en série entre lesdites électrodes des cellules du panneau d'affichage au plasma, des troisième et quatrième diodes (D3,D4) étant montées respectivement en parallèle avec lesdits troisième et quatrième interrupteurs (M3,M4), la cathode de ladite troisième diode (D3) étant connectée à une électrode des cellules du panneau et l'anode de ladite quatrième diode (D4) étant connectée à une autre électrode des cellules du panneau et à la borne négative de la source de tension continue, et
- un circuit de commande pour commander l'ouverture et la fermeture des interrupteurs en mode découpage afin de générer une rampe de tension programmable sur les électrodes des cellules du panneau,dans lequel, pour générer ladite rampe de tension, au moins un desdits interrupteurs (M1-M4) fonctionne en mode découpage.

2. Dispositif selon la revendication 1, **caractérisé en ce que** pour générer une rampe de tension croissante, ledit quatrième interrupteur (M4) fonctionne en mode découpage tandis que ledit premier interrupteur (M1) est placé dans un état fermé et les deuxième et troisième interrupteurs (M2,M3) sont placés dans un état ouvert.

3. Dispositif selon la revendication 1, **caractérisé en ce que** pour générer une rampe de tension croissante, lesdits premier et quatrième interrupteurs (M1,M4) fonctionnent en mode découpage de manière synchronisée tandis que lesdits deuxième et troisième interrupteurs (M2,M3) sont placés dans un état ouvert.

4. Dispositif selon l'une des revendications 1 à 3, **caractérisé en ce que** pour générer une rampe de tension décroissante, lesdits deuxième et troisième interrupteurs (M2, M3) fonctionnent en mode découpage de manière synchronisée tandis que lesdits premier et quatrième interrupteurs (M1,M4) sont placés dans un état ouvert.
